# EUROPEAN PATENT APPLICATION

(11) **EP 1 550 540 A2**
(43) Date of publication of application: **06.07.2005**
(21) Application number: 04293149.3
(22) Date of filing: 28.12.2004
(51) Int. Cl.: B29C 33/60, B29D 11/00, B29C 45/37, G02B 3/00, C23C 22/02

(54) **Microstructure mold and method for coating the same**

(30) Priority: 31.12.2003 KR 2003102239
(71) Applicant: LG ELECTRONICS INC., Seoul (KR)
(72) Inventor: Yee, Young-Joo Maehwamaeul Jugong Apt. 210-604, Seongnam Gyeonggi-do (KR); Oh, Chang-Hoon, Gwanak-Gu, Seoul (KR); Kwon, Hyouk, Gwanak-gu, Seoul (KR); Lee, Gun-Woo, Dalseo-Gu, Daegu (KR); Park, Ki-Won, Donan-Gu, Anyang, Gyeonggi-Do (KR); Seong, Dong-Mug, Ansan, Gyeonggi-Do (KR)
(74) Representative: Loisel, Bertrand

(57) **Abstract**

A microstructure mold (10) according to the present invention has a self assembled monolayer (13) formed of a surfactant on a surface thereof thereby not to impede a precision of the mold (10) and simultaneously to have a proper releasing performance of a molding as well as to improve corrosion resistance thereof. Furthermore, it is advantageous to dramatically reduce processing costs by maintaining a uniform thickness of the monolayer without using a complex equipment.

## Description

### BACKGROUND OF THE INVENTION

### 1. Field of the Invention

The present invention relates to a microstructure mold and a method for coating the same, and particularly, to a microstructure mold and a method for coating the same capable of easily releasing moldings from a mold in order to minimize damage such as abrasion, contamination, or the like occurred on a mold surface during molding a microstructure using a mold.

### 2. Description of the Conventional Art

In general, there has used molding techniques such as an injection molding, a press molding, an extrusion molding or the like for reproducing or molding a high polymer like a plastic by using a mold. The molding method using the mold is advantageous to mold the same molding rapidly and repeatedly. However, in the molding method using the mold, when a molding material is poured into the mold and hardened therein, thereafter separating a molding from the mold, the molding may partially remain in the mold. During this, if the molding is re-produced without performing a washing process, the molding is not properly molded and its life may be shortened. In particular, those problems may be worse when manufacturing moldings having a microstructure by using a microstructure mold.

In order to solve those problems, there has used a process by which the remnant on the mold is periodically removed using a periodical washing process or a physical or chemical method. For those processes, however, a great deal of time is required therefor, which causes a decrease of a productivity and an increase of manufacturing costs.

Moreover, there has used a method for coating a release agent to allow moldings to be easily released from the mold surface manufacturing moldings having a microstructure. As a method for coating the release agent, in detail, there have used the following methods, namely, a spray coating method for spraying the release agent diluted at a certain concentration on a contact surface between the mold and the molding or a plasma coating method for coating a plasma thin film on a contact surface between the mold and the molding through a process using the plasma.

However, a thickness of the release agent is differently coated according to a shape of a mold surface in case of using the spray coating method so that the method may be difficult to apply in case of the mold surface having a complicated shape. It also causes a precision of the mold surface to be impeded.

Furthermore, processes of the plasma coating method are complicated so as to increase producing costs remarkably.

Therefore, it is required to develop a method how to reliably coat the release agent at a uniform thickness on the mold surface with lower costs.

### SUMMARY OF THE INVENTION

Therefore, an object of the present invention is to provide a microstructure mold and a method for coating the same capable of improving durability and corrosion resistance of a mold by minimizing damage such as abrasion, contamination or the like occurred on a mold surface during molding a microstructure using the mold and capable of easily releasing moldings from a mold.

To achieve these and other advantages and in accordance with the purpose of the present invention, as embodied and broadly described herein, there is provided a microstructure mold characterized by coating a monolayer on a surface thereof for release from moldings.

Another embodiment of the present invention, there is provided a method for coating a microstructure mold including: a first step of wetting a microstructure mold surface with a solution obtained by mixing a surfactant and an organic solvent; a second step of the surfactant's reacting upon the mold surface thereby coating the monolayer formed of the surfactant on the mold surface; a third step of removing the surfactant, which has not reacted upon the mold surface, from the mold surface; and a fourth step of drying a microstructure mold on which the monolayer is formed.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
Figure 1 is a perspective view showing a microstructure mold and moldings formed thereby in accordance with an embodiment of the present invention;
Figure 2 is a plane figure of the microstructure mold shown in Figure 1;
Figure 3 is a cross-sectional view according to a cut-line III-III shown in Figure 2;
Figure 4 is an enlarged view showing a main part A shown in Figure 3; and
Figure 5 is an enlarged view showing a main part B shown in Figure 4.

### DETAILED DESCRIPTION OF THE PREFERRED EMBODIMENTS

Reference will now be made in detail to the preferred embodiments of the present invention, examples of which are illustrated in the accompanying drawings.

Hereinafter, it will be described about an embodiment of a microstructure mold and a method for coating the same in accordance with the present invention with reference to the accompanying drawings.

There may exist various embodiments for the microstructure mold and the method for coating the same in accordance with the present invention, but it will be explained of the most preferred embodiment therefor hereinafter.

First, the microstructure mold in accordance with an embodiment of the present invention will be explained with reference to the accompanying drawing.

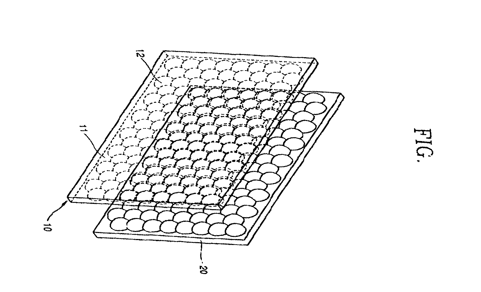

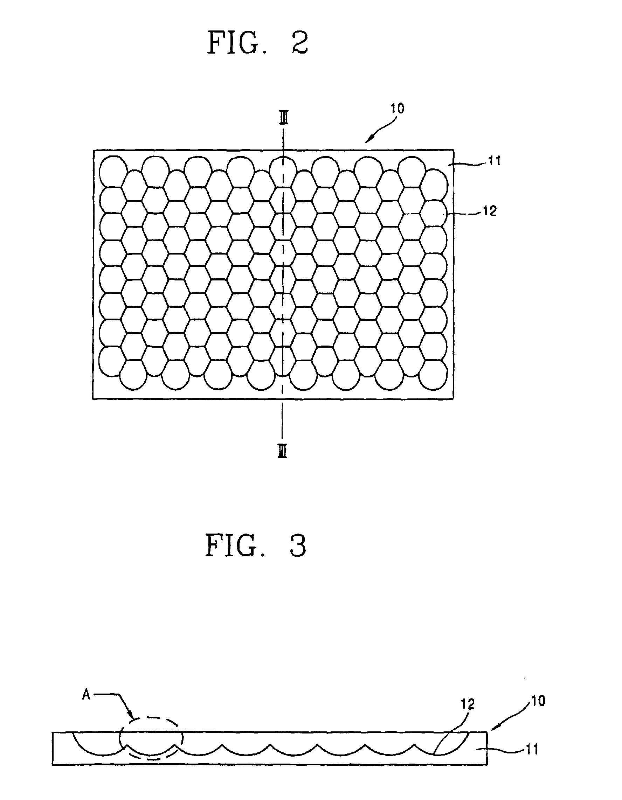

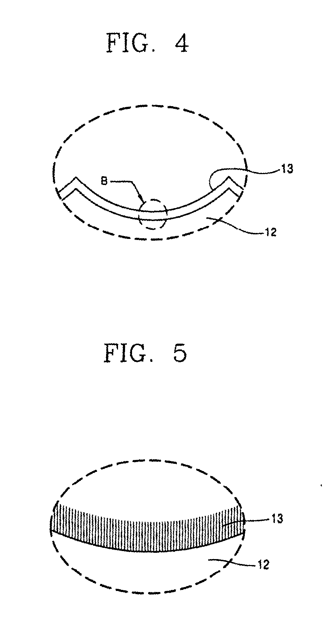

Figure 1 is a perspective view showing a microstructure mold and moldings formed thereby according to an embodiment of the present invention, Figure 2 is a plane view of the microstructure mold shown in Figure 1, Figure 3 is a cross-sectional view according to a cut-line III-III shown in Figure 2, Figure 4 is an enlarged view showing a main part A shown in Figure 3;and Figure 5 is an enlarged view showing a main part B shown in Figure 4. As shown in the drawings, the microstructure mold 10 in accordance with an embodiment of the present invention includes: a mold substrate 11 having a microstructure pattern 12 to be transferred to a molding 20 on one surface thereof; and a monolayer coated on the mold substrate 11 in order to facilitate the mold to be released from the molding 20.

Here, the mold 10 is generally manufactured by using an MEMS (Micro Electro Mechanical System) technique which includes electroplating or electroless plating on a master in which a certain microstructure pattern is defined. Or, the microstructure pattern 12 formed at the mold 10 may be manufactured by a mechanical working.

The embodiment, as can be seen from the drawings, shows the microstructure mold for manufacturing a micro-lens array having an outer diameter at a range of a micron to one millimeter.

As shown in the drawings, a surfactant bonding to the surface of the mold 10 is used as a release agent forming the monolayer 13. That is, the surfactant containing a precursor having a particular functional group and a hydrophobic chain structure forms the monolayer 13.

Furthermore, as shown in Figure 5, by having the functional group capable of reacting upon a substrate, the surfactant is bonded well to the mold 10 surface by a chemical adsorption and well aligned by itself. That is, the surfactant forms a monolayer called Self Assembled Monolayer (SAM) by a self assembly method on the surface of the mold 10.

The surfactant is bonded to the mold surface by a van der Waals' force and a covalent bonding so that it can be strongly bonded to the surface of the mold 10.

On the other hand, the surfactant forming the monolayer 13 is appropriately selected according to a material of the mold 10.

That is, in case of forming the mold 10 of one of materials such as cuprum (Cu), nickel (Ni), palladium (Pd), aurum (Au), and argentum (Ag), a thiol-based precursor is preferably used as the surfactant.

In particular, in case of using Au as the material of the mold 10, one of precursors, namely, a sulfides, disulfides, RSO₂H and R₃P is preferably selected and used as the surfactant.

As a matter of course, as aforementioned, it is possible to select and use a type of the surfactant properly according to the material of the mold 10.

It will be now explained in detail how the monolayer formed of a release agent is coated on a microstructure mold in accordance with an embodiment of the present invention.

A method for coating a microstructure mold in accordance with an embodiment of the present invention includes: a first step of wetting a surface of the microstructure mold 10 with a mixed solution of a surfactant and an organic solvent; a second step of the surfactant's reacting upon the surface of the mold 10 and then coating a monolayer 13 formed of the surfactant on the surface of the mold 10; a third step of removing the surfactant without having reacted upon the surface of the mold 10 therefrom; and a fourth step of drying the microstructure mold 10 on which the monolayer 13 has been formed.

A molar concentration of the mixed solution should be decided within a proper range in order to obtain a superior coating monolayer 13, namely, preferably within the range of 1 mM to 10mM.

Also, N and N-dimethylformamide (DMF) are usually used as the organic solvent mixed with the surfactant.

There are several methods for wetting the mold 10 with the mixed solution in the first step as follows.

First, a dipping method can be explained therefor. That is, by dipping the mold in the mixed solution for a certain time, the surfactants in the mixed solution are bonded to the surface of the mold 10 by a van der Waals' force and a covalent bonding thereby to form the monolayer 13.

As another method therefor, by preparing a proper passage to flow the mixed solution and putting the mold 10 into the passage, the surface of the mold 10 is reacted upon the surfactant in the mixed solution flowing in the passage thereby to form the monolayer 13. According to this, a characteristic of thin film of the monolayer 13 can be improved and a processing time can be shortened.

As a matter of course, in addition to the aforementioned methods, the mold 10 can be surely reacted upon the surfactant by using other methods.

Such formed monolayer 13 is the SAM formed by the self assembly method as stated above.

On the other hand, it is preferred to wash the mold with the organic solvent prior to the first step. After completing the washing process, the surfactant can be bonded to the surface of the mold 10 better.

Passing through the second step, the monolayer 13 is formed on the surface of the mold 10 but the mixed solution containing a surfactant which hasn't been bonded to the surface of the mold 10 still remains on the surface of the mold 10. Therefore, it is necessary to remove the residual mixed solution from the surface of the mold 13. For this, in the third step, the surface of the mold having the monolayer 13 thereon is washed with the organic solvent such as acetone, isoprophyl alcohol or the like and thus the mixed solution containing the surfactant remaining on the mold surface is removed.

Finally, in the fourth step, the mold 10 is dried under 100°C for a certain time through a thermal stabilization process and the residual organic solvent on the surface of the mold 13 is completely evaporated and also the monolayer 13 is coated on the surface of the mold 10 more strongly.

Here, the self assembled monolayer 13 is about several nanometers (nm) thick. Accordingly, the monolayer 13 has a proper releasing performance without impeding a precision of the microstructure pattern 12 formed on the mold 10, thereby easily releasing the molding 20 from the mold 10.

As aforementioned, in case that the mold on which the monolayer is coated is formed of one of materials, namely, cuprum (Cu), nickel (Ni), palladium (Pd), aurum (Au) and argentum (Ag), a thiol-based precursor is preferably selected as the surfactant. In particular, in case of using Au as the material of the mold 10, one of precursors, namely, a sulfides, disulfides, RSO₂H and R₃P is preferably selected and used as the surfactant.

As stated so far, the microstructure mold and the method for coating the same are provided, by which the microstructure mold can have a proper releasing performance without impeding precision of the mold by coating a coating material formed of the surfactant on the mold surface with a monolayer which is several namometers (nm) thick

Furthermore, the coating layer formed on the microstructure mold of the present invention is obtained by a wetting method such as dipping it in the mixed solution containing the surfactant using a principle for forming the self assembled monolayer (SAM). In response to this, the coating layer can maintain its uniform thickness without using a complex equipment like a plasma evaporation. According to this, processing costs can be remarkably reduced such by minimizing capital investment costs required for coating and a mass production using semiconductor integrated process is possible.

Also, the coating layer of the microstructure mold of the present invention is formed on the mold surface by a covalent bonding and a van der Waals' force so that it is bonded to the mold surface with relatively high bond energy in comparison to the existing coating method. Therefore, reliability of the mold and the molding formed thereby can be improved and corrosion resistance of the mold surface can be improved as well.

Accordingly, the microstructure mold and the method for coating the same in accordance with the present invention can be utilized for a microstructure mold including such a micro-lens array seat manufactured by a micromachining and an MEMS (Micro Electromechanical System) technique.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A microstructure mold having a monolayer coated on a surface thereof for release from a molding.

2. The microstructure mold of claim 1, wherein the monolayer is formed by bonding a surfactant on the mold surface

3. The microstructure mold of claim 2, wherein the monolayer is formed by a self assembly method.

4. The microstructure mold of claim 2, wherein a material of the mold is one of cuprum (Cu), nickel (Ni), palladium (Pd), aurum (Au) and argentum (Ag).

5. The microstructure mold of claim 4, wherein the surfactant is a thiol-based precursor.

6. The microstructure mold of claim 2, wherein the material of the mold is aurum (Au).

7. The microstructure mold of claim 6, wherein the surfactant is one of precursors, namely, sulfides, disulfides, RSO₂H and R₃P.

8. The microstructure mold of claim 2, wherein the surfactant is bonded on the mold surface according to a van der Waals' force and a covalent bonding.

9. The microstructure mold of claim 1, wherein the microstructure mold is a mold for molding a micro-lens array seat.

10. A method for coating a microstructure mold comprising:
a first step of wetting a microstructure mold surface with a solution obtained by mixing a surfactant and an organic solvent;
a second step of the surfactant's reacting upon the mold surface thereby coating the monolayer formed of the surfactant on the mold surface;
a third step of removing the surfactant, which has not reacted upon the mold surface, from the mold surface; and
a fourth step of drying the microstructure mold on which the monolayer is formed.

11. The method of claim 10, wherein a molar concentration of the mixed solution is 1 mM to 10mM.

12. The method of claim 10, wherein the first step is achieved by dipping the mold in the mixed solution for a certain time.

13. The method of claim 10, wherein the first step is achieved by flowing the mixed solution into a passage formed in the mold.

14. The method of claim 10, wherein further comprising a step of washing the mold with an organic solvent prior to the first step.

15. The method of claim 10, wherein the organic solvent is N and N-dimethylformamide (DMF).

16. The method of claim 10, wherein the monolayer is formed by a self assembly method.

17. The method of claim 10, wherein in the third step, the mold surface where the monolayer is formed is washed with the organic solvent thereby to remove a mixed solution containing the surfactant remaining on the mold surface.

18. The method of claim 10, wherein in the fourth step, the mold is dried through a thermal stabilization process under 100°C for a certain time.

19. The method of claim 10, wherein the material of the mold is one of cuprum (Cu), nickel (Ni), palladium (Pd), aurum (Au), and argentum (Ag).

20. The microstructure mold of claim 19, wherein the surfactant is a thiol-based precursor.

21. The microstructure mold of claim 10, wherein the material of the mold is aurum (Au).

22. The microstructure mold of claim 21, wherein the surfactant is one of precursors, namely, sulfides, disulfides, RSO₂H and R₃P.

23. The method of claim 10, wherein the monolayer is formed by bonding the surfactant on the mold surface depending on a van der Waals' force and a covalent bonding.
